# EUROPEAN PATENT APPLICATION

(11) **EP 4 215 486 A1**
(43) Date of publication of application: **26.07.2023**
(21) Application number: 21869346.3
(22) Date of filing: 14.09.2021
(51) Int. Cl.: C01F 5/08, H01L 23/29, H01L 23/31, C08L 101/00, C08K 3/013, C08K 3/22

(54) **MAGNESIUM OXIDE POWDER, FILLER COMPOSITION, RESIN COMPOSITION, AND HEAT DISSIPATING COMPONENT**

(30) Priority: 15.09.2020 JP 2020154418
(71) Applicant: Denka Company Limited, Tokyo 103-8338 (JP); Tateho Chemical Industries Co., Ltd., Ako-shi, Hyogo 678-0239 (JP)
(72) Inventor: SASAKI, Shuji, Tokyo 103-8338 (JP); NAKAZONO, Junichi, Tokyo 103-8338 (JP); TANOUE, Shotaro, Tokyo 103-8338 (JP); OSAKI, Yoshihisa, Ako-shi, Hyogo 678-0239 (JP); CHIKAZAWA, Tomoaki, Ako-shi, Hyogo 678-0239 (JP); YAMAMOTO, Miki, Ako-shi, Hyogo 678-0239 (JP)
(74) Representative: Zacco Sweden AB
(86) International application number: PCT/JP2021/033637
(87) International publication number: WO 2022/059659

(57) **Abstract**

An object of the present invention is to provide a magnesium oxide powder, including a specific magnesium oxide particle, that can suppress an increase in viscosity when a resin is filled therewith and can realize high thermal conduction of a resin composition including the resin, and a filler composition, a resin composition, and a heat dissipation part including the magnesium oxide powder. The magnesium oxide powder of the present invention includes a magnesium oxide particle, wherein an oil absorption of the magnesium oxide particle in the case of linseed oil measured according to JIS K 5101-13-1 is 2.5 mL/10 g or less.

## Description

### Technical Field

The present invention relates to a magnesium oxide powder, a filler composition, a resin composition, and a heat dissipation part.

### Background Art

In recent years, the miniaturization and higher performance of an electrical device have been progressing. With the miniaturization and higher performance, the packaging density of an electronic part constituting an electrical device is increasing, and the need to effectively dissipate heat generated from an electronic part is increasing.

In addition, in an application of a power device in an electric vehicle or the like that can suppress an environmental load, a high voltage may be applied to an electronic part or a large current may flow therethrough. In this case, a large amount of heat is generated, and in order to cope with the large amount of heat generated, there is an increasing demand for more effective dissipation of heat than before.

As a technique for responding to such a demand, a resin composition including a thermally conductive filler is used. For example, a magnesium oxide particle is used as the thermally conductive filler, and Patent Document 1 discloses a specific spherical magnesium oxide particle.

### Citation List

### Patent Document

Patent Document 1: Japanese Patent Laid-Open No. 2018-131378

### Summary of Invention

### Technical Problem

However, the magnesium oxide particle has low dispersibility in a resin and thickens when a resin is filled with the magnesium oxide particle, and thus the filling ability is low.

In this regard, Patent Document 1 adjusts the content of each of boron and iron within a certain range to obtain a spherical magnesium oxide particle having a high sphericity and a smooth particle surface, and uses this particle to improve the ability to fill a resin. However, this has the following problem: the addition of the impurities of boron and iron lowers the thermal conductivity of the magnesium oxide particle itself, and lowers the thermal conductivity of the resulting heat dissipation part.

The present invention has been made in view of such a problem, and an object thereof is to provide a magnesium oxide powder, including a specific magnesium oxide particle, that can suppress an increase in viscosity when a resin is filled therewith and can realize high thermal conduction of a resin composition including the resin, and a filler composition, a resin composition, and a heat dissipation part including the magnesium oxide powder.

### Solution to Problem

The present inventors have carried out diligent studies in order to achieve the above object and as a result, have found that a magnesium oxide powder including a specific magnesium oxide particle has a low oil absorption and thus can suppress an increase in viscosity when a resin is filled therewith, and it is possible to obtain a resin composition and a heat dissipation part that can realize high thermal conduction by including the magnesium oxide powder, and have completed the present invention.

That is, the present invention is as follows.
[1] A magnesium oxide powder containing a magnesium oxide particle, wherein an oil absorption of the magnesium oxide particle in the case of linseed oil measured according to JIS K 5101-13-1 is 2.5 mL/10 g or less.
[2] A filler composition containing the magnesium oxide powder according to [1] and an inorganic filler other than the magnesium oxide particle.
[3] The filler composition according to [2], wherein the inorganic filler is an alumina particle, a content ratio of the magnesium oxide particle is 40% by volume or more and 70% by volume or less, a content ratio of the alumina particle is 30% by volume or more and 60% by volume or less, the alumina particle contains a first alumina particle having an average particle diameter of 0.1 µm or more and less than 1.0 µm, and a second alumina particle having an average particle diameter of 1.0 µm or more and less than 10 µm, and each of the average particle diameters is a particle diameter measured by using a laser light diffraction scattering particle size distribution analyzer.
[4] A resin composition containing a resin and the filler composition according to [2] or [3].
[5] A heat dissipation part containing the magnesium oxide powder according to [1], the filler composition according to [2] or [3], or the resin composition according to [4].

### Advantageous Effects of Invention

According to the present invention, it is possible to provide a magnesium oxide powder that can suppress an increase in viscosity when a resin is filled therewith and can realize high thermal conduction of a resin composition including the resin, and a filler composition, a resin composition, and a heat dissipation part including the magnesium oxide powder.

### Brief Description of Drawings

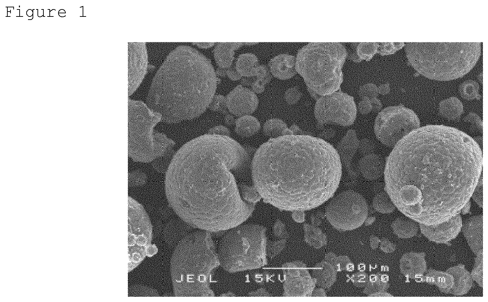

[Figure 1] Figure 1 shows an SEM image (200 times) of the magnesium oxide particle according to the present embodiment when observed by using a scanning electron microscope.

### Description of Embodiments

Hereinafter, an embodiment of the present invention (hereinafter, simply referred to as "the present embodiment") will be described in detail. The following present embodiment is an illustration for describing the present invention, and the present invention is not limited only to the present embodiment.

### [Magnesium oxide powder]

The magnesium oxide powder of the present embodiment includes a magnesium oxide particle according to the present embodiment, which will be described later.

### (Magnesium oxide particle)

In the magnesium oxide particle according to the present embodiment, the oil absorption of the magnesium oxide particle in the case of linseed oil measured according to JIS K 5101-13-1 is 2.5 mL/10 g or less. Hereinafter, unless otherwise specified, the magnesium oxide particle according to the present embodiment is also simply referred to as the "magnesium oxide particle," and the magnesium oxide powder including the magnesium oxide particle according to the present embodiment is also simply referred to as the "magnesium oxide powder."

The oil absorption of the magnesium oxide particle is preferably 2.2 mL/10 g or less, and more preferably 1.8 mL/10 g or less, from the viewpoint of further improving the moldability when a resin is filled therewith. The lower limit thereof is not particularly limited, and is 0.1 mL/10 g or more. The oil absorption is measured by the method described in the Examples.

A conventional magnesium oxide particle has a high oil absorption and easily absorbs a resin, and thus has low dispersibility in the resin. Because of this, when the resin is filled with the conventional magnesium oxide particle, thickening occurs, making it difficult to fill the resin with such a magnesium oxide particle at a high proportion.

However, the magnesium oxide particle according to the present embodiment has an oil absorption of 2.5 mL/10 g or less. The magnesium oxide powder of the present embodiment includes a magnesium oxide particle having an oil absorption in the above range, and thus the fluidity of the magnesium oxide powder in the resin is improved, the frictional resistance with the resin is lowered, and it is possible to suppress an increase in viscosity when the resin is filled with the magnesium oxide powder. As a result, the resin can be filled with the magnesium oxide powder at a high proportion, and the magnesium oxide particles are sufficiently in contact with each other in the resin, and the contact area becomes large. Because of this, a heat path can be efficiently formed, and a more highly thermally conductive resin composition and heat dissipation part can be obtained.

In the present embodiment, the content ratio of a double oxide on the surface based on the magnesium oxide particle is preferably less than 10% by mass, and more preferably 5% by mass or less, when the total content ratio of the magnesium oxide particle and the double oxide on the surface of the particle is 100% by mass, from the viewpoint of being able to further suppress a decrease in thermal conductivity. The lower limit thereof is not particularly limited, and is 0% by mass or more. In the present embodiment, the surface of the magnesium oxide particle is more preferably not coated with a double oxide. Examples of the double oxide include one including magnesium and one or more elements selected from the group consisting of aluminum, iron, silicon, and titanium. Examples of such a double oxide include forsterite (Mg₂SiO₄), spinel (Al₂MgO₄), magnesium ferrite (Fe₂MgO₄), and magnesium titanate (MgTiO₃) . In the present embodiment, the oil absorption is reduced by controlling the surface state and shape of the magnesium oxide particle without coating the surface of the magnesium oxide particle with a double oxide or the like. In the present embodiment, a coating layer may not be present on the surface of the magnesium oxide particle. That is, the magnesium oxide particle may be uncoated.

The content ratio of magnesium oxide in the magnesium oxide particle according to the present embodiment is preferably 100% by mass per 100% by mass of the magnesium oxide particle, from the viewpoint of being able to further realize high thermal conduction of the resin composition. That is, preferably, the magnesium oxide particle according to the present embodiment does not include an impurity or another component and consists only of magnesium oxide.

The magnesium oxide particle has a higher particle strength (single granule compressive strength) at a cumulative fracture rate of 63.2%, measured according to JIS R 1639-5:2007, of preferably 50 MPa or more and 140 MPa or less, and more preferably 60 MPa or more and 120 MPa or less, from the viewpoint of further improving the moldability when the resin is filled therewith. When the particle strength is less than 50 MPa, the aggregated particles may collapse because of stress during kneading with the resin, pressing, or the like, to lower the thermal conductivity. In addition, when the particle strength exceeds 140 MPa, the mold and the apparatus may be worn. The value of "63.2%" in the cumulative fracture rate is a value that satisfies ln[ln(1/(1 - F(t)))] = 0 in the Weibull distribution function described in JIS R 1625:2010 cited by JIS R 1639-5:2007 and that is based on the number of particles. The particle strength is measured by the method described in the Examples.

The magnesium oxide particle having a projected area equivalent circle diameter of 1 µm or more and 300 µm or less as determined by the following microscopy has an average sphericity of preferably 0.82 or more and 0.97 or less. When the magnesium oxide particle is spherical in such a way as to have an average sphericity in the above range, the surface of the particle becomes smoother and the oil absorption becomes lower, and thus thickening is less likely to occur when a resin is filled with the magnesium oxide particle, making it possible to fill the resin with the magnesium oxide particle at a high proportion. The average sphericity thereof is preferably 0.84 or more and 0.95 or less, and more preferably 0.86 or more and 0.93 or less, from the viewpoint of lowering the frictional resistance when the resin is filled therewith and increasing the contact area between the particles. The average sphericity is measured, for example, by the following microscopy. That is, a particle image taken by using a scanning electron microscope, a transmission electron microscope, or the like is taken into an image analyzer, and the projected area (A) and the perimeter (PM) of the particle are measured from the photograph (magnification: 200 times). When the area of a perfect circle having the same perimeter as the perimeter (PM) is (B), the sphericity of the particle is A/B. Therefore, when envisioning a perfect circle having the same perimeter as the perimeter (PM) of a sample, PM = 2πr and B = πr², and thus B = π × (PM/2π)², and the sphericity of each particle is sphericity = A/B = A × 4π/(PM)². The sphericity of each of 200 arbitrary particles having a projected area equivalent circle diameter of 1 µm or more and 300 µm or less is determined as described above, and the arithmetic mean value thereof is taken as the average sphericity. For a specific measurement method, the description in the Examples can be referred to. In addition, the projected area equivalent circle diameter refers to the diameter of a perfect circle having the same projected area as the projected area (A) of a particle.

The magnesium oxide particle has a low oil absorption because the surface of the particle is smooth. Because of this, the resin can be highly filled with the magnesium oxide particle, and thus the contact between the magnesium oxide particles becomes better, a heat path can be formed efficiently and well, and a more highly thermally conductive resin composition and heat dissipation part can be obtained. The average particle diameter is preferably 30 µm or more and 150 µm or less, more preferably 40 µm or more and 140 µm or less, and more preferably 50 µm or more and 130 µm or less, from the viewpoint of being able to suitably obtain such an effect and also providing surface smoothness when a resin composition is formed. When the average particle diameter is 30 µm or more, a heat path can be formed more efficiently in the resin composition and the heat dissipation part, and heat tends to be able to be conducted more sufficiently. In addition, when the average particle diameter is 150 µm or less, the smoothness of the surface of the heat dissipation part is further improved, and the thermal resistance at the interface between the heat dissipation part and a heat source is reduced, and thus the thermal conductivity tends to be able to be improved more sufficiently. In the present embodiment, and the particle diameter and the average particle diameter are measured by using a laser light diffraction scattering particle size distribution analyzer. A specific measurement method is as described in the Examples.

### (Magnesium oxide powder)

In the present embodiment, the content ratio of the magnesium oxide particle according to the present embodiment in the magnesium oxide powder is preferably 80% by mass or more, more preferably 85% by mass or more, further preferably 90% by mass or more, and further more preferably 99% by mass or more, per 100% by mass of the magnesium oxide powder. The upper limit of the content ratio thereof is, for example, 100% by mass. The magnesium oxide powder having a content ratio of the magnesium oxide particle within the above range includes an unavoidable component such as silicon dioxide, which tends to inhibits a heat path, and an aid (for example, boron and iron) used in the production of the magnesium oxide particle in a further reduced amount, and thus a more highly thermally conductive resin composition and heat dissipation part tends to be able to be obtained. The content ratio of the magnesium oxide particle is measured by the method described in the Examples.

The magnesium oxide powder according to the present embodiment usually does not include a filler other than the magnesium oxide particle according to the present embodiment. Examples of such a filler include an inorganic filler, an organic filler, and an organic-inorganic hybrid filler. Specific examples of the inorganic filler include a filler made of an inorganic substance such as a magnesium oxide particle other than the magnesium oxide particle according to the present embodiment, a silica particle, an alumina particle, an aluminum nitride particle, a silicon nitride particle, an yttrium oxide particle, a boron nitride particle, a calcium oxide particle, an iron oxide particle, and a boron oxide particle. Examples of the organic filler include a filler made of an organic substance such as a homopolymer of one of or a copolymer of two or more of styrene, vinyl ketone, acrylonitrile, methyl methacrylate, ethyl methacrylate, glycidyl methacrylate, glycidyl acrylate, methyl acrylate, and the like; a fluorine-based resin such as polytetrafluoroethylene, a tetrafluoroethylene-hexafluoropropylene copolymer, a tetrafluoroethylene-ethylene copolymer, and polyvinylidene fluoride; a melamine resin; a urea resin; polyethylene; polypropylene; or polymethacrylate. Examples of the organic-inorganic hybrid filler include a filler including polysilsesquioxane. As will be described later, the filler composition according to the present embodiment includes the magnesium oxide powder according to the present embodiment and an inorganic filler other than the magnesium oxide particle according to the present embodiment.

The particle density of the magnesium oxide powder is preferably 3.0 g/cm³ or more and 3.5 g/cm³ or less, and more preferably 3.1 g/cm³ or more and 3.4 g/cm³ or less, from the viewpoint of further improving the thermal conductivity. When the particle density of the magnesium oxide powder is in the above range, the magnesium oxide powder is lighter than the normal magnesium oxide powder, and thus the weight of the heat dissipation part can be reduced. In addition, such a particle density also exerts the effect of being able to reduce wear on the mold and the apparatus. The particle density is measured by the method described in the Examples.

### (Method for producing magnesium oxide particle)

The magnesium oxide particle and the magnesium oxide powder according to the present embodiment can be produced, for example, by including the following steps (1) to (5).
(1) A step of mixing an aqueous solution obtained by mixing magnesium chloride and water with an alkaline aqueous solution and reacting these to obtain a magnesium hydroxide slurry,
(2) a step of filtering, washing with water, and drying the magnesium hydroxide slurry and then firing the same to obtain a magnesium oxide particle,
(3) a step of adding a solvent such as an organic solvent to the magnesium oxide particle to prepare a dispersion liquid, and then carrying out wet grinding in the dispersion liquid,
(4) a step of next carrying out spray drying to obtain a magnesium oxide particle, and
(5) a step of firing the magnesium oxide particle to obtain a magnesium oxide powder including the magnesium oxide particle according to the present embodiment.

In this production method, a boron source and an iron source are mixed and/or added such that the boron content of the magnesium oxide powder of the present embodiment is 300 ppm or more and 2,000 ppm or less and the iron content is 100 ppm or more and 1,500 ppm or less before the final firing. Specifically, in the above steps (1) to (3), the boron content and the iron content of the magnesium oxide powder of the present embodiment can be adjusted by adding or mixing the boron source and/or the iron source in any one or more of (a) the magnesium chloride aqueous solution, (b) the magnesium hydroxide slurry, (c) the magnesium oxide particle obtained in step (2), and (d) the dispersion liquid and/or the wet grinding in the dispersion liquid.

When the boron content in the magnesium oxide powder of the present embodiment is less than 300 ppm, the surface may not be smoothed and the moisture resistance may deteriorate. In addition, when the boron content exceeds 2,000 ppm, a depression may be formed in a part of the sphere or a donut-shaped magnesium oxide particle may be formed, and magnesium oxide particle having a high sphericity may not be obtained.

When the iron content of the magnesium oxide powder of the present embodiment is less than 100 ppm, the moisture resistance may deteriorate and a depression may be formed in a part of the sphere, and thus magnesium oxide particle having a high sphericity may not be obtained. In addition, when the iron content exceeds 1,500 ppm, a large number of fine particles may be generated on the surface of magnesium oxide particle, and the moisture resistance may deteriorate.

The boron source is not particularly limited as long as it is a compound including boron, and examples thereof include boric acid, boron oxide, boron hydroxide, boron nitride, boron carbide, and ammonium borate.

The iron source is not particularly limited as long as it is a compound including iron, and examples thereof include iron(II) oxide, iron(III) oxide, triiron tetroxide, iron hydroxide, iron chloride, iron nitride, iron bromide, and iron fluoride.

Examples of magnesium chloride include magnesium chloride hexahydrate, magnesium chloride dihydrate, magnesium chloride anhydrate, bittern, seawater, and mixtures thereof.

Examples of the alkaline aqueous solution include a sodium hydroxide aqueous solution, a calcium hydroxide aqueous solution, aqueous ammonia, and mixtures thereof.

Examples of the solvent added to the magnesium oxide particle in step (3) include a known organic solvent. Examples thereof include methanol, ethanol, propanol, butanol, pentanol, ethylene glycol monomethyl ether, ethylene glycol monoethyl ether, propylene glycol monoethyl ether, diethylene glycol monomethyl ether, dipropylene glycol monoethyl ether, ethylene glycol, propylene glycol, diethylene glycol, triethylene glycol, glycerin, trimethylolpropane, pentaerythritol, acetone, formic acid, acetic acid, propionic acid, tetrahydrofuran, and toluene, and mixed solvents thereof.

In step (3), it is necessary to prepare a dispersion liquid in a slurry state including the magnesium oxide particle in an amount of 50% by mass or more per 100% by mass of the dispersion liquid. It is effective to add a dispersant in order to increase the slurry concentration while suppressing a decrease in the dispersibility of the slurry. As the dispersant, a known dispersant can be used. The magnesium oxide according to the present embodiment can be obtained by adjusting the slurry concentration to a high level and raising the drying temperature of the spray drying in step (4). The upper limit of the slurry concentration is 90% by mass or less.

In addition, as the wet grinding, a known grinding method such as grinding using a ball mill can be used.

In step (4), the method of spray drying is not particularly limited, and it is preferable to use, for example, a spray drying method involving spraying the magnesium oxide dispersion liquid after wet grinding from a rotating disk or a nozzle to obtain a magnesium oxide particle. In addition, the dispersion liquid at the time of wet grinding and spraying is preferably adjusted such that the content ratio of the magnesium oxide is 50% by mass or more and 80% by mass or less in the dispersion liquid.

In step (4), the drying temperature is 60°C or more. As described above, it is important to increase the slurry concentration in step (3) and to raise the drying temperature of the spray drying in step (4). The drying temperature is 180°C or less.

In addition, the smoothness of the particle surface can also be improved by increasing the slurry concentration in step (3) and raising the drying temperature of the spray drying in step (4).

In step (5), the firing conditions of the magnesium oxide particle are not particularly limited as long as the magnesium oxide particle is sintered, and the firing temperature is preferably 1,000°C or more and 1,800°C or less, more preferably 1,100°C or more and 1,700°C or less, and further preferably 1,200°C or more and 1,600°C or less. When the firing temperature is less than 1,000°C, the magnesium oxide particle may not be sufficiently sintered. When the firing temperature exceeds 1,800°C, the particles may be sintered to each other to form a coarse aggregate. The firing time is not particularly limited depending on the firing temperature, and is preferably 0.5 hours or more and 10 hours or less.

### [Filler composition]

The filler composition according to the present embodiment includes the magnesium oxide powder according to the present embodiment and a filler other than the magnesium oxide particle according to the present embodiment. Examples of such a filler include an inorganic filler, an organic filler, and an organic-inorganic hybrid filler. These are the same as those given as examples above, and specific examples thereof will be omitted. Among these, an inorganic filler is preferable, and an alumina particle is more preferable. In addition, in the present embodiment, the filler composition may include various additives. Examples of such additives include a silane coupling agent and a wet dispersant.

Examples of the filler other than the magnesium oxide particle according to the present embodiment include a magnesium oxide particle having an oil absorption in the case of linseed oil measured according to JIS K 5101-13-1 of more than 2.5 mL/10 g, which is other than the magnesium oxide particle according to the present embodiment. The upper limit thereof is not particularly limited, and is 5.0 mL/10 g or less.

These fillers may be fillers surface-treated by using a known silane coupling agent or the like. The filler composition may include one or two or more of these fillers together with the magnesium oxide particle according to the present embodiment.

The filler composition according to the present embodiment preferably includes the magnesium oxide powder according to the present embodiment and an alumina particle. By including these, the filler composition according to the present embodiment can suppress thickening and can have a high thermal conduction property.

### (Alumina particle)

The alumina particle according to the present embodiment include one alumina particle or two or more alumina particles different in average particle diameter from each other. In addition, instead of the alumina particle, an alumina powder including an alumina particle and a filler other than the alumina particle, particularly an inorganic filler, may be used. When such an alumina powder includes a filler other than the alumina particle and other than an inorganic filler, the powder should be referred to as a mere powder rather than an alumina powder.

In the present embodiment, the content ratio of the alumina particle in the alumina powder is preferably 80% by mass or more, more preferably 85% by mass or more, further preferably 90% by mass or more, and further more preferably 99% by mass or more, per 100% by mass of the alumina powder. The upper limit of the content ratio thereof is, for example, 100% by mass. When the alumina powder includes two or more alumina particles different in average particle diameter from each other, the content ratio of the alumina particles is the total content ratio of these particles. The alumina powder having an alumina particle content ratio within the above range further includes an unavoidable component such as silicon dioxide, which tends to inhibit a heat path, in a further reduced amount, and thus a more highly thermally conductive resin composition and heat dissipation part tend to be able to be obtained.

In the filler composition of the present embodiment, the content ratio of the magnesium oxide particle is preferably 40% by volume or more and 70% by volume or less, and more preferably 45% by volume or more and 65% by volume or less per 100% by volume of the filler composition, from the viewpoint of being able to further improve the thermal conductivity and being able to further suppress a decrease in the ability to fill the resin therewith. In addition, when the filler composition of the present embodiment includes an alumina particle together with the magnesium oxide powder, the content ratio of the alumina particle is preferably 30% by volume or more and 60% by volume or less, and preferably 35% by volume or more and 55% by volume or less per 100% by volume of the filler composition, from the viewpoint of being able to further improve the thermal conductivity and being able to further suppress a decrease in the ability to fill the resin therewith.

By including the magnesium oxide powder and an alumina particle within their respective ranges above, the filler composition according to the present embodiment can further suppress an increase in viscosity when a resin is filled therewith, and can further realize high thermal conduction of a resin composition including the resin.

The alumina particle preferably includes a first alumina particle having an average particle diameter of 0.1 µm or more and less than 1.0 µm, and a second alumina particle having an average particle diameter of 1.0 µm or more and less than 10 µm. The role of the first alumina particle is to promote the fluidity between particles, the role of the second alumina particle is to efficiently fill a gap in the magnesium oxide powder and promote the ability to fill a resin, and the combination of these allows the effect of further improving the moldability to be obtained. In order to obtain this effect, the content ratio of the first alumina particle is preferably 8% by volume or more and 20% by volume or less, and more preferably 12% by volume or more and 17% by volume or less per 100% by volume of the filler composition. In addition, the content ratio of the second alumina particle is preferably 22% by volume or more and 40% by volume or less, and more preferably 23% by volume or more and 38% by volume or less. The particle diameter of the alumina particle is measured, for example, by using a laser light diffraction scattering particle size distribution analyzer.

When the filler composition includes a further filler other than the magnesium oxide powder and the alumina particle, the content ratio thereof may be 40% by volume or less, 30% by volume or less, 20% by volume or less, 15% by volume or less, 10% by volume or less, or 5% by volume or less per 100% by volume of the filler composition. In addition, the filler composition may not include a further filler.

The filler composition of the present embodiment has a plurality of peaks, that is, two or more peaks, preferably two or more and four or less peaks, and more preferably three peaks, in the particle size range of a particle diameter of 0.01 µm or more and 3,500 µm or less. Here, in the present embodiment, the peak refers to a maximum point detected in a particle diameter range obtained by dividing a particle diameter range of 0.01 µm or more and 3,500 µm or less into 100 equal parts at equal intervals (provided that the region of the smallest particle diameter is 0.01 µm or more and 35 µm or less and the region of a particle diameter larger than that is divided at intervals of 35 µm) in a volume-based frequency particle size distribution obtained by a laser light diffraction scattering method. When a detected peak has a shoulder, the shoulder is also counted as a peak. The shoulder is detected by the curvature of a peak given by the second differential coefficient and means that there is an inflection point in the peak, that is, there are more particle components having a specific particle diameter.

In addition, for the individual peaks, the particle having the first peak is referred to as the first particle, the particle having the second peak is referred to as the second particle, and successively the particle having the nth peak is referred to as the nth particle, the peaks being detected from the fine particle side (that is, the 0.01 µm side) in the particle size range of a particle diameter of 0.01 µm or more and 3,500 µm or less in a volume-based frequency particle size distribution obtained by a laser light diffraction scattering method. That is, the number of detected peaks is n. The detected particles may be only the magnesium oxide particle according to the present embodiment and an alumina particle, and may be a filler other than the magnesium oxide particle and alumina particle in addition thereto. In addition, the detected particles are preferably the magnesium oxide particle according to the present embodiment and two or more alumina particles different in average particle diameter from each other, and more preferably the magnesium oxide particle according to the present embodiment and two alumina particles different in average particle diameter from each other.

### (Method for producing filler composition)

As the filler composition according to the present embodiment, one magnesium oxide powder according to the present embodiment may be used as it is. In addition, the filler composition according to the present embodiment may be obtained by appropriately mixing two or more magnesium oxide powders. Further, the filler composition according to the present embodiment may be obtained by appropriately mixing the magnesium oxide powder according to the present embodiment with a filler other than that or the like. Examples of a mixing method include ball mill mixing.

### [Resin composition and method for producing the same]

The resin composition according to the present embodiment includes a resin and the magnesium oxide powder according to the present embodiment. In addition, the resin composition according to the present embodiment includes a resin and the filler composition according to the present embodiment. By including the above magnesium oxide powder, the resin composition according to the present embodiment can suppress thickening and can have a high thermal conduction property.

The thermal conductivity of the resin composition according to the present embodiment is 5.5 (W/m•K) or more, and may be 7.0 (W/m•K) or more, or 10.0 (W/m•K) or more. The thermal conductivity is measured by the method described in the Examples.

### (Resin)

As the resin, various polymer compounds such as a thermoplastic resin, an oligomer thereof, and an elastomer can be used. For example, an epoxy resin, a phenol resin, a melamine resin, a urea resin, an unsaturated polyester, a urethane resin, an acrylic resin, and a fluororesin; a polyamide such as polyimide, polyamideimide, and polyetherimide; a polyester such as polybutylene terephthalate and polyethylene terephthalate; polyphenylene sulfide, aromatic polyester, polysulfone, a liquid crystal polymer, polyether sulfone, a polycarbonate, a maleimide modified resin, ABS (acrylonitrile/butadiene/styrene) resin, AAS (acrylonitrile/acrylic rubber/styrene) resin, AES (acrylonitrile/ethylene/propylene/diene rubber/styrene) resin, EVA (ethylene vinyl acetate copolymer) resin, and a silicone resin can be used. One of these resins can be used alone or two or more thereof can be appropriately mixed and used.

Among these resins, from the viewpoint of obtaining a high heat dissipation characteristic, an epoxy resin, a phenol resin, a urethane resin, an acrylic resin, a fluororesin, polyimide, polyphenylene sulfide, a polycarbonate, ABS resin, and a silicone resin are preferable, a silicone resin, an epoxy resin, a urethane resin, and an acrylic resin are more preferable, and a silicone resin is further preferable.

As the silicone resin, it is preferable to use a rubber or gel obtained from a one-component or two-component addition reaction type liquid silicone having an organic group such as a methyl group and a phenyl group. Examples of such a rubber or gel include "YE5822A Liquid/YE5822B Liquid (trade name)" manufactured by Momentive Performance Materials Japan LLC and "SE1885A Liquid/SE1885B Liquid (trade name)" manufactured by Dow Corning Toray Co., Ltd.

### (Magnesium oxide powder, alumina particle, and resin filling ratio)

In the resin composition of the present embodiment, the filling ratio of the magnesium oxide powder according to the present embodiment is preferably 67% by volume or more and 88% by volume or less, and more preferably 71% by volume or more and 85% by volume or less, per 100% by mass of the resin composition, from the viewpoint of improving the thermal conductivity. In this case, the filling ratio of the resin (solid) is preferably 12% by volume or more and 33% by volume or less, and more preferably 15% by volume or more and 29% by volume or less, from the viewpoint of moldability of the resin composition.

In addition, when the resin composition of the present embodiment includes an alumina particle, the total filling ratio of the magnesium oxide powder according to the present embodiment and the alumina particle is preferably 67% by volume or more and 88% by volume or less, and more preferably 71% by volume or more and 85% by volume or less, per 100% by mass of the resin composition, from the viewpoint of further improving the thermal conductivity. The filling ratio of the resin (solid) is preferably 12% by volume or more and 33% by volume or less, and more preferably 15% by volume or more and 29% by volume or less, from the viewpoint of moldability of the resin composition.

The magnesium oxide powder according to the present embodiment does not easily thicken even when the resin is filled therewith, and thus even if the magnesium oxide powder is included in the resin composition within the above range, the thickening of the resin composition can be suppressed.

### (Other components)

In addition to the magnesium oxide particle according to the present embodiment, an alumina particle, and a resin, the resin composition of the present embodiment may include, as necessary, an inorganic filler such as fused silica, crystalline silica, zircon, calcium silicate, calcium carbonate, silicon carbide, aluminum nitride, boron nitride, beryllia, and zirconia; a flame retardant compound such as a nitrogen-containing compound such as melamine and benzoguanamine, an oxazine ring-containing compound, and a phosphate compound of a phosphorus-based compound, an aromatic condensed phosphoric acid ester, and a halogen-containing condensed phosphoric acid ester; an additive, or the like, as long as the characteristics of the present embodiment are not impaired. Examples of the additive include a reaction retarder such as dimethyl maleate, a curing agent, a curing accelerator, a flame retardant aid, a flame retardant, a colorant, a tackifier, a UV absorber, an antioxidant, a fluorescent whitener, a photosensitizer, a thickener, a lubricant, an antifoamer, a surface conditioner, a brightener, and a polymerization inhibitor. One of these components can be used alone or two or more thereof can be appropriately mixed and used. In the resin composition of the present embodiment, the content ratio of each of the other components is usually 0.1% by mass or more and 5% by mass or less per 100% by mass of the resin composition. In addition, the total content ratio of the other components may be 40% by mass or less, 30% by mass or less, 20% by mass or less, 15% by mass or less, 10% by mass or less, or 5% by mass or less per 100% by mass of the resin composition. In addition, the resin composition may not include such other components.

### (Method for producing resin composition)

Examples of a method for producing the resin composition of the present embodiment include a method involving sufficiently stirring a resin, the magnesium oxide powder, and, as necessary, an alumina particle and other components to obtain the resin composition. The resin composition of the present embodiment can be produced, for example, by blending a predetermined amount of each component by using a blender, a Henschel mixer, or the like, molding the resulting mixture by a doctor blade method, an extrusion method, a press method, or the like depending on the viscosity of the mixture, and heat-curing the resulting molded product.

### [Heat dissipation part]

The heat dissipation part according to the present embodiment includes the magnesium oxide powder, the filler composition, or the resin composition according to the present embodiment. By using the above magnesium oxide powder, filler composition, or resin composition, the heat dissipation part according to the present embodiment can realize a high thermal conduction property, that is, can have a high heat dissipation property. Examples of the heat dissipation part include a heat dissipation sheet, a heat dissipation grease, a heat dissipation spacer, a semiconductor encapsulant, and a heat dissipation coating material (heat dissipation coating agent).

### Examples

Examples and Comparative Examples will be shown below, and the present invention will be described in detail, but the present invention is not limited by these Examples at all.

### [Evaluation methods]

### (1) Oil absorption

According to JIS K 5101-13-1, while linseed oil (Linseed Oil (trade name) manufactured by Kanto Chemical Co., Inc.) was added dropwise to 10 g of the magnesium oxide particle obtained in each of the Examples and the Comparative Examples, these were kneaded together, the time point when the whole became one hard mass was regarded as the endpoint, and the amount of linseed oil at that time was taken as the oil absorption (mL/10 g).

### (2) Content ratio of double oxide

The content ratio of a double oxide in the magnesium oxide powder was measured by Rietveld analysis of a powder X-ray diffraction pattern. The magnesium oxide powder obtained in each of the Examples and the Comparative Examples was packed in a sample holder, and measured by using an X-ray diffractometer ("D8 ADVANCE" (product name), detector: LynxEye (product name), manufactured by Bruker Corporation). The measurement conditions were X-ray source: CuKα (λ = 1.5406 Å), measurement method: continuous scanning method, scan speed: 0.017°/1.0 sec, tube voltage: 40 kV, tube current: 40 mA, divergence slit: 0.5°, solar slit: 2.5°, and measurement range: 2θ = 10° to 70°. Based on the obtained X-ray diffraction pattern, the content ratio (% by mass) of the double oxide in the magnesium oxide powder was determined by quantitative analysis according to Rietveld analysis using the analysis software TOPAS.

### (3) Particle strength

The measurement was carried out according to JIS R 1639-5:2007. As a measurement apparatus, a microcompression tester ("MCT-W500" (trade name) manufactured by Shimadzu Corporation) was used. For the particle strength (σ, unit: MPa) of the magnesium oxide particle obtained in each of the Examples and the Comparative Examples, 20 or more particles were measured and the values thereof at a cumulative fracture rate of 63.2% were each calculated from a dimensionless number (α = 2.48) that varied depending on the position in the particle, the compressive test force (P, unit: N), and the particle diameter (d, unit: µm) by using the expression σ = α × P/(π × d²), and the average value thereof was taken as the particle strength (MPa). When the average particle diameter was less than 20 µm, the particle diameter was too small and thus the particle strength was unable to be calculated.

### (4) Average sphericity

As described in the above microscopy, particle images of 200 arbitrary particles taken by using a scanning electron microscope ("Model JSM-6301F" (trade name) manufactured by JEOL Ltd.) were taken into an image analyzer ("MacView Ver.4" (trade name) manufactured by Mountech Co., Ltd.), and the projected area (A) and the perimeter (PM) of the magnesium oxide particle obtained in each of the Examples and the Comparative Examples were measured from the photographs. These values were used to determine the sphericities of the individual particles, and the arithmetic mean value of the sphericities of the individual particles was taken as the average sphericity. By this method, the average sphericity of magnesium oxide particles having a projected area equivalent circle diameter of 1 µm or more and 300 µm or less was measured. As a reference, an SEM image (200 times) of the magnesium oxide particle according to the present embodiment is shown in Figure 1.

### (5) Average particle diameter and particle size distribution (number of peaks)

The average particle diameter and the particle size distribution (number of peaks) were measured by using a laser light diffraction scattering particle size distribution analyzer("Mastersizer 3000" (trade name) manufactured by Malvern Panalytical Ltd, equipped with wet dispersion unit: Hydro MV). At the time of measurement, the magnesium oxide powder or the filler composition obtained in each of the Examples and the Comparative Examples to be measured was subjected to a pretreatment for 2 minutes in water, and to dispersion treatment with application of an output of 200 W by using Ultrasonic Disruptor UD-200 (equipped with Ultramicrotip TP-040) (trade name) manufactured by TOMY SEIKO Co., Ltd. The particle after the dispersion treatment was dropped onto the dispersion unit such that the laser light diffraction scattering intensity was 10% or more and 15% or less. The stirring speed of the dispersion unit stirrer was 1750 rpm, and the ultrasonic mode was "no." The analysis of the particle size distribution was carried out by dividing the range of a particle diameter of 0.01 µm or more and 3500 µm or less into 100 parts. The refractive indexes of water, magnesium oxide, and the alumina particle used were 1.33, 1.74, and 1.768, respectively. In the measured mass-based particle size distribution, the particle having a cumulative mass of 50% was taken as the average particle diameter (µm). In addition, a maximum point detected in the above particle size range was taken as a peak.

### (6) Content ratio of magnesium oxide particle

The content ratio of the magnesium oxide particle in the magnesium oxide powder was measured by Rietveld analysis of a powder X-ray diffraction pattern. The magnesium oxide powder obtained in each of the Examples and the Comparative Examples were packed in a sample holder, and measured by using an X-ray diffractometer ("D8 ADVANCE" (product name), detector: LynxEye (product name), manufactured by Bruker Corporation). The measurement conditions were X-ray source: CuKα (λ = 1.5406 Å), measurement method: continuous scanning method, scan speed: 0.017°/1.0 sec, tube voltage: 40 kV, tube current: 40 mA, divergence slit: 0.5°, solar slit: 2.5°, and measurement range: 2θ = 10° to 70°. Based on the obtained X-ray diffraction pattern, the content ratio (% by mass) of the magnesium oxide particle in the magnesium oxide powder was determined by quantitative analysis according to Rietveld analysis using the analysis software TOPAS.

### (7) Particle density

The particle density (g/cm³) of the magnesium oxide powder obtained in each of the Examples and the Comparative Examples was measured by using the continuous automatic powder/granular material true density measuring instrument "Auto True Denser MAT-7000 (trade name) manufactured by Seishin Enterprise Co., Ltd." Ethanol (special grade reagent) was used as a measurement solvent.

### (8) Viscosity

The filler composition obtained in each of the Examples and the Comparative Examples was added to silicone oil ("KF96-100cs" (trade name) manufactured by Shin-Etsu Chemical Co., Ltd.)) such that the total filling ratio of the magnesium oxide powder and the alumina particle in the filler composition was 75% by volume. This was mixed by using a rotation/revolution mixer ("Awatori Rentaro ARE-310" (trade name) manufactured by THINKY Corporation) at a rotation speed of 2,200 rpm for 30 seconds, and then vacuum defoamed to obtain a resin composition. The shear viscosity of the obtained resin composition was measured by using a rheometer ("MCR102" (trade name) manufactured by Antonio-Paar GmbH). The measurement conditions were temperature: 30°C, plate: ϕ25 mm parallel plate, and gap: 1 mm. The viscosity was measured while continuously changing the shear rate from 0.01 s⁻¹ to 10 s⁻¹, and the viscosity (Pa•s) at 7 s⁻¹ was read.

### (9) Thermal conductivity

The filler composition obtained in each of the Examples and the Comparative Examples was added to a silicone resin (SE-1885A Liquid and SE1885B Liquid manufactured by Dow Corning Toray Co., Ltd.) such that the total filling ratio of the magnesium oxide powder and the alumina particle in the filler composition was 80% by volume. This was stirred and mixed, then vacuum defoamed, processed into a thickness of 3 mm, and then heated at 120°C for 5 hours to obtain a resin composition. The thermal conductivity (W/m•K) of the obtained resin composition was measured by using a thermal conductivity measuring apparatus (resin material thermal resistance measuring apparatus "TRM-046RHHT" (trade name) manufactured by Hitachi Technologies and Services, Ltd.) and by a steady state method based on ASTM D5470. The resin composition was processed into a width of 10 mm × 10 mm, and the measurement was carried out while applying a load of 5 N.

### (Production of magnesium oxide particle 1)

Magnesium chloride anhydrate (MgCl₂) was dissolved in ion exchange water to prepare an about 3.5 mol/L aqueous solution of magnesium chloride. The aqueous solution of magnesium chloride and a 25% aqueous solution of sodium hydroxide were each sent to a reactor by using a metering pump such that the reaction rate of magnesium chloride was 90 mol%, and a continuous reaction was carried out to obtain a magnesium hydroxide slurry.

To the magnesium hydroxide slurry, boric acid (manufactured by Kanto Chemical Co., Inc., special grade reagent) was added such that the boron content of the magnesium oxide powder finally obtained was 650 ppm, and iron(II) oxide (manufactured by Hayashi Pure Chemical Ind., Ltd.) was added such that the iron content was 350 ppm. After that, the slurry was filtered, washed with water, and dried, and then fired at 900°C for 1 hour to obtain a magnesium oxide particle.

An industrial alcohol (Solmix A-7 (trade name) manufactured by Japan Alcohol Trading Co., Ltd.)) was added to the magnesium oxide particle to obtain a dispersion liquid having a concentration of the magnesium oxide particle of 55% by mass. In this dispersion liquid, wet grinding was carried out for 4 hours by using a ball mill.

After that, spray drying was carried out by a spray drying method. The drying temperature was 70°C.

The obtained magnesium oxide particle after spray drying was fired at 1,600°C for 1 hour by using an electric furnace to obtain a magnesium oxide powder containing magnesium oxide particle 1.

The physical characteristics of the obtained magnesium oxide particle 1 and powder were each evaluated according to the above evaluation methods. As a result, the oil absorption was 2.5 mL/10 g, the content ratio of the double oxide was 0% by mass, the particle strength was 83 MPa, the average sphericity was 0.89, the average particle diameter was 124 µm, the content ratio of the magnesium oxide particle was 100% by mass, and the particle density was 3.4 g/cm³.

### (Production of magnesium oxide particle 2)

A magnesium oxide powder containing magnesium oxide particle 2 was produced in the same manner as in Example 1 except that the concentration of the magnesium oxide particle was changed to 40% by mass.

The physical characteristics of the obtained magnesium oxide particle 2 and powder were each evaluated according to the above evaluation methods. As a result, the oil absorption was 2.9 mL/10 g, the content ratio of the double oxide was 0% by mass, the particle strength was 51 MPa, the average sphericity was 0.91, the average particle diameter was 95 µm, the content ratio of the magnesium oxide particle was 100% by mass, and the particle density was 3.6 g/cm³.

### (Production of magnesium oxide particle 3)

A magnesium oxide powder containing magnesium oxide particle 3 was produced in the same manner as in Example 1 except that the concentration of the magnesium oxide particle was changed to 60% by mass and the drying temperature in the spray drying by the spray drying method was changed to 85°C.

The physical characteristics of the obtained magnesium oxide particle 3 and powder were each evaluated according to the above evaluation methods. As a result, the oil absorption was 2.2 mL/10 g, the content ratio of the double oxide was 0% by mass, the particle strength was 112 MPa, the average sphericity was 0.86, the average particle diameter was 105 µm, the content ratio of the magnesium oxide particle was 100% by mass, and the particle density was 3.4 g/cm³.

### (Production of magnesium oxide particle 4)

A magnesium oxide powder containing magnesium oxide particle 4 was produced in the same manner as in Example 1 except that the concentration of the magnesium oxide particle was changed to 60% by mass and the drying temperature in the spray drying by the spray drying method was changed to 100°C.

The physical characteristics of the obtained magnesium oxide particle 4 and powder were each evaluated according to the above evaluation methods. As a result, the oil absorption was 1.8 mL/10 g, the content ratio of the double oxide was 0% by mass, the particle strength was 92 MPa, the average sphericity was 0.92, the average particle diameter was 101 µm, the content ratio of the magnesium oxide particle was 100% by mass, and the particle density was 3.3 g/cm³.

### [Examples 1 to 5 and Comparative Examples 1 and 2]

Magnesium oxide particles 1 to 4 and alumina particles 1 to 3 were blended at proportions (% by volume) shown in Table 1 to obtain filler compositions. The physical properties of the obtained filler compositions were evaluated, and results thereof are shown in Table 1. "DAW-07" (trade name, average particle diameter: 7 µm) manufactured by Denka Company Limited was used as alumina particle 1, "DAW-05" (trade name, average particle diameter: 5 µm) manufactured by Denka Company Limited was used as alumina particle 2, and "AA-05" (trade name, average particle diameter: 0.5 µm) manufactured by Sumitomo Chemical Co., Ltd. was used as alumina particle 3.

**[Table 1]**

| | | Example 1 | Example 2 | Example 3 | Example 4 | Example 5 | Comparative Example 1 | Comparative Example 2 |
|---|---|---|---|---|---|---|---|---|
| Filler composition (% by volume) | | | | | | | | |
| | Magnesium oxide particle 1 | 50 | | | 60 | | | |
| | Magnesium oxide particle 2 | | | | | | 50 | 60 |
| | Magnesium oxide particle 3 | | 50 | | | | | |
| | Magnesium oxide particle 4 | | | 50 | | 60 | | |
| | Alumina particle 1 (DAW-07) | 35 | | | 40 | | | |
| | Alumina particle 2 (DAW-05) | | 35 | 35 | | 40 | 35 | 40 |
| | Alumina particle 3 (AA-05) | 15 | 15 | 15 | | | 15 | |

| Evaluations | | | | | | | | |
|---|---|---|---|---|---|---|---|---|
| | Number of peaks | 3 | 3 | 3 | 2 | 2 | 3 | 2 |
| | Viscosity (Pa·s) | 100 | 80 | 72 | 103 | 78 | 150 | 168 |
| | Thermal conductivity (W/m·K) | 8.1 | 9.1 | 9.3 | 7.5 | 8.4 | 5.1 | 4.7 |

The present application claims priority based on a Japanese patent application (Japanese Patent Application No. 2020-154418) filed with the Japan Patent Office on September 15, 2020, the contents of which are incorporated herein by reference.

### Industrial Applicability

According to the magnesium oxide powder of the present invention, it is possible to suppress an increase in viscosity when a resin is filled therewith, and it is possible to realize high thermal conduction of a resin composition including the resin. Because of this, the magnesium oxide powder is particularly useful in an application of a heat dissipation part such as a heat dissipation sheet, a heat dissipation grease, a heat dissipation spacer, a semiconductor encapsulant, and a heat dissipation coating material (heat dissipation coating agent).

## Claims

1. A magnesium oxide powder comprising a magnesium oxide particle, wherein
an oil absorption of the magnesium oxide particle in the case of linseed oil measured according to JIS K 5101-13-1 is 2.5 mL/10 g or less.

2. A filler composition comprising the magnesium oxide powder according to claim 1 and an inorganic filler other than the magnesium oxide particle.

3. The filler composition according to claim 2, wherein the inorganic filler is an alumina particle,
a content ratio of the magnesium oxide particle is 40% by volume or more and 70% by volume or less,
a content ratio of the alumina particle is 30% by volume or more and 60% by volume or less,
the alumina particle comprises a first alumina particle having an average particle diameter of 0.1 µm or more and
less than 1.0 µm, and a second alumina particle having an average particle diameter of 1.0 µm or more and less than 10 µm, and
each of the average particle diameters is a particle diameter measured by using a laser light diffraction scattering particle size distribution analyzer.

4. A resin composition comprising a resin and the filler composition according to claim 2 or 3.

5. A heat dissipation part comprising the magnesium oxide powder according to claim 1, the filler composition according to claim 2 or 3, or the resin composition according to claim 4.
